(19) Europäisches Patentamt
European Patent Office
Office européen des brevets

(11) **EP 2 721 684 B1**

(12) **FASCICULE DE BREVET EUROPEEN**

(45) Date de publication et mention
de la délivrance du brevet:
**27.05.2015 Bulletin 2015/22**

(21) Numéro de dépôt: **12730831.0**

(22) Date de dépôt: **12.06.2012**

(51) Int Cl.:
***H01M 10/44*** *(2006.01)*      ***H01M 10/48*** *(2006.01)*
***H02J 7/00*** *(2006.01)*

(86) Numéro de dépôt international:
**PCT/EP2012/061119**

(87) Numéro de publication internationale:
**WO 2012/171919 (20.12.2012 Gazette 2012/51)**

(54) **SYSTEME DE BATTERIES D'ACCUMULATEURS A SUPERVISION SIMPLIFIEE**

BATTERIEZELLENSYSTEM MIT VEREINFACHTER ÜBERWACHUNG

SYSTEM OF BATTERIES OF CELLS WITH SIMPLIFIED MONITORING

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **14.06.2011  FR 1155181**

(43) Date de publication de la demande:
**23.04.2014  Bulletin 2014/17**

(73) Titulaire: **Renault S.A.S.**
**92100 Boulogne-Billancourt (FR)**

(72) Inventeurs:
• **BERANGER, Marc**
**F-38410 Saint Martin D'Uriage (FR)**
• **RANIERI, Marco**
**F-38610 Gieres (FR)**

(74) Mandataire: **Colombo, Michel**
**Brevinnov**
**310 avenue Berthelot**
**69008 Lyon (FR)**

(56) Documents cités:
**JP-A- 2009 089 453      US-A1- 2004 189 248
US-A1- 2006 132 089**

**Description**

L'invention concerne les batteries d'accumulateurs électrochimiques. Celles-ci peuvent par exemple être utilisées dans le domaine des transports électriques et hybrides ou les systèmes embarqués.

Un accumulateur électrochimique a habituellement une tension nominale de l'ordre de grandeur suivant:

> 1.2 V pour des batteries de type NiMH,
> 3.3 V pour une technologie Lithium ion phosphate de fer, LiFePO4,
> 3.7 V pour une technologie de type Lithium ion à base d'oxyde de cobalt.

Ces tensions nominales sont trop faibles par rapport aux exigences de la plupart des systèmes à alimenter. Pour obtenir le niveau de tension adéquat, on place en série plusieurs accumulateurs. Pour obtenir de fortes puissances et capacités, on place plusieurs groupes d'accumulateurs en série. Le nombre d'étages (nombre de groupes d'accumulateurs) et le nombre d'accumulateurs en parallèle dans chaque étage varient en fonction de la tension, du courant et de la capacité souhaités pour la batterie. L'association de plusieurs accumulateurs est appelée une batterie d'accumulateurs.

La charge d'un accumulateur se traduit par une croissance de la tension à ses bornes. Chaque technologie d'accumulateur présente un profil de charge qui lui est propre, par exemple défini par l'évolution de la tension d'un accumulateur dans le temps pour un courant de charge donné.

On considère un accumulateur chargé par exemple lorsque, sous un courant donné, celui-ci a atteint un niveau de tension nominal défini par son processus électrochimique. Si la charge est interrompue avant que cette tension ne soit atteinte, l'accumulateur n'est pas complètement chargé. L'accumulateur peut aussi être considéré comme chargé lorsque la charge a duré un temps prédéterminé ou encore lorsque le courant de charge, alors que l'accumulateur est maintenu à tension constante, a atteint une valeur seuil minimale.

Du fait de dispersions de fabrication, les accumulateurs présentent en pratique des caractéristiques différentes. Ces différences, relativement faibles lorsque la batterie est neuve, s'accentuent avec l'usure hétérogène des accumulateurs de la batterie. Même en associant des accumulateurs d'un même lot de fabrication dans une batterie, des dispersions subsistent. La charge de la batterie est généralement supervisée par un dispositif de contrôle à partir de mesures de tension sur les différents accumulateurs.

La plage de fonctionnement d'un accumulateur de type Li - ion à base d'oxyde de cobalt est typiquement comprise entre 2,7 V et 4,2 V. Une utilisation hors de cette plage peut induire une détérioration irréversible des accumulateurs de la batterie. Une surcharge peut conduire à une destruction d'un accumulateur, à son usure accélérée (par dégradation de l'électrolyte), ou à une explosion par un phénomène d'emballement thermique. Des dispositifs de contrôle connus surveillent ainsi la charge de chaque accumulateur. La charge de tous les accumulateurs est donc interrompue lorsque l'accumulateur le plus chargé atteint une limite haute de la plage de fonctionnement. La tension de l'accumulateur le moins chargé est alors égale à une tension inférieure à la limite haute.

Le dispositif de contrôle interrompt également la décharge de la batterie lorsque l'accumulateur le moins chargé atteint une limite basse de la plage de fonctionnement.

Par conséquent, différentes connectiques sont connues pour permettre au dispositif de contrôle de vérifier le niveau de charge de chacun des accumulateurs. Pour accroître le niveau de sécurité de la batterie, il est également fréquent d'utiliser des connectiques permettant au dispositif de contrôle de vérifier d'autres paramètres de fonctionnement, tels que la température des accumulateurs.

Selon une structure connue en présence de nombreux accumulateurs, un circuit de mesure de tension et de température est fixé sur chaque accumulateur. Le dispositif de contrôle comprend plusieurs cartes esclaves gérées par une carte maître ou calculateur, ces cartes étant regroupées. Chaque carte esclave est connectée à plusieurs circuits de mesure, par exemple 8 ou 16, par l'intermédiaire de câblages point à point.

Dans une telle structure, les accumulateurs se trouvent à des tensions échelonnées atteignant des niveaux élevés. Ainsi, les mesures de tension doivent soit être isolées galvaniquement, soit être conçues pour une tension de mode commun élevée. Dans un véhicule automobile, le calculateur est généralement alimenté par une batterie 12 V, dédiée à l'alimentation du réseau de bord et des accessoires. La batterie du réseau de bord étant connectée à la masse du véhicule, il peut en outre s'avérer nécessaire de réaliser un isolement galvanique pour la communication entre les cartes esclaves et le calculateur. De plus, la connexion filaire point à point entre les circuits de mesures et les cartes esclaves nécessite un grand nombre de connexions et une longueur de faisceau conséquente. Par conséquent, une telle conception induit un coût et une complexité non négligeables. Par ailleurs, le nombre de connexions filaires point à point multiplie les risques de court-circuit avec une connexion directe aux accumulateurs, ce qui nécessite une conception et une réalisation particulièrement soignées impliquant notamment l'intégration de protections (fusibles ou disjoncteurs).

Le document JP2009-089453 décrit une batterie munie de plusieurs accumulateurs connectés en série, d'un circuit de mesure de la tension aux bornes de la batterie, d'un circuit de communication et d'un circuit de contrôle. Le circuit de communication indique au circuit de contrôle une variation de tension lorsque la tension aux bornes de la batterie franchit un seuil.

Selon une autre structure connue en présence de nombreux accumulateurs, un circuit de mesure de tension et de température est fixé sur chaque accumulateur. Les circuits de mesure sont connectés à un même bus de communication. Un calculateur récupère les informations transmises par les circuits de mesures sur ce bus de communication.

Une telle structure permet d'éviter des inconvénients des connexions filaires point à point. Cependant, une telle structure nécessite la présence d'un bus de conception particulière disposant d'un isolement galvanique, du fait des niveaux de tension auxquels il est soumis. Une attention très particulière doit être apportée à la conception du bus, celui-ci étant connecté à des niveaux de tension élevés à l'intérieur de la batterie. Ainsi, un isolement galvanique coûteux et complexe doit être mis en oeuvre et l'intégration d'un tel bus dans une batterie pose des problèmes pratiques.

L'invention vise à résoudre un ou plusieurs de ces inconvénients. L'invention porte ainsi sur un système de batterie d'accumulateurs, comprenant :

- plusieurs accumulateurs électrochimiques connectés en série ;
- une connexion électrique de puissance destinée à raccorder une charge électrique ou une alimentation de recharge auxdits accumulateurs électrochimiques ;
- un dispositif de contrôle raccordé aux accumulateurs électrochimiques par l'intermédiaire de la connexion électrique de puissance.

Le système comprend en outre :

- plusieurs circuits de mesure, chacun de ces circuits de mesure étant accolé à un accumulateur électrochimique respectif et étant configuré pour mesurer la tension aux bornes de cet accumulateur respectif ;
- plusieurs circuits de communication, chacun de ces circuits de communication étant accolé à un accumulateur électrochimique respectif et étant configuré pour induire une baisse de tension aux bornes de cet accumulateur respectif lorsque la tension mesurée franchit un seuil.

Le dispositif de contrôle est configuré pour identifier ladite baisse de tension.

Selon une variante, les circuits de mesure et les circuits de communication sont alimentés électriquement par leur accumulateur respectif.

Selon une autre variante, les circuits de communication sont configurés pour induire une alternance de baisses de tension avec une fréquence comprise entre 10kHz et 1 MHz lorsque la tension mesurée franchit un seuil.

Selon encore une variante, les circuits de communication sont configurés pour induire une baisse de tension aux bornes de leur accumulateur respectif soit lorsque la tension aux bornes de cet accumulateur franchit une tension de charge maximale, soit lorsque la tension aux bornes de cet accumulateur franchit une tension de décharge minimale.

Selon encore une autre variante, les circuits de communication sont configurés pour induire une baisse de tension pour la tension de charge maximale avec un rapport cyclique supérieur au rapport cyclique de la baisse de tension pour la tension de décharge minimale.

Selon une variante, les circuits de communication sont configurés pour réaliser des baisses de tension distinctes, le dispositif de contrôle étant configuré pour identifier un circuit de communication en fonction de la baisse de tension réalisée.

Selon encore une variante, le système comprend :

- un convertisseur continu/alternatif connecté à la connexion électrique de puissance ;
- un filtre antiparasitage interposé entre le convertisseur et le dispositif de contrôle.

Selon une autre variante, le système comprend plus de vingt accumulateurs connectés en série, la tension aux bornes de la batterie étant supérieure à 50V.

Selon encore une autre variante, les circuits de communication sont configurés pour induire une baisse de tension d'au moins 0,1 % aux bornes de leur accumulateur lorsque la tension mesurée franchit un seuil.

Selon une variante, les circuits de communication induisent une baisse de tension aux bornes de leur accumulateur par connexion d'une charge électrique entre les bornes de leur accumulateur.

L'invention porte également sur un procédé de gestion de la charge d'accumulateurs électrochimiques en série d'une batterie, comprenant les étapes de :

- mesure de la tension aux bornes des accumulateurs par l'intermédiaire de circuits de mesure accolés à des accumulateurs respectifs ;
- détection du franchissement d'un seuil de tension aux bornes de son accumulateur respectif par un desdits circuits de mesure ;
- génération d'une baisse de tension aux bornes de l'accumulateur pour lequel le franchissement a été détecté ;
- détection de la baisse de tension par un dispositif de contrôle raccordé aux accumulateurs électrochimiques par l'intermédiaire d'une connexion électrique de puissance raccordant une charge électrique ou une alimentation de recharge auxdits accumulateurs.

Selon une variante, le procédé comprend l'alimentation des circuits de mesure par leur accumulateur respectif.

Selon une autre variante, la génération d'une baisse de tension inclut une alternance de baisses de tension aux bornes dudit accumulateur avec une fréquence comprise entre 10kHz et 1 MHz.

Selon encore une variante, la génération d'une baisse de tension comprend la connexion d'un élément électrique aux bornes dudit accumulateur, ledit élément électrique étant configuré pour induire une baisse de tension d'au moins 0,1 % aux bornes dudit accumulateur lors de sa connexion.

D'autres caractéristiques et avantages de l'invention ressortiront clairement de la description qui en est faite ci-après, à titre indicatif et nullement limitatif, en référence aux dessins annexés, dans lesquels :

- la figure 1 est une représentation schématique d'un système de batterie d'accumulateurs selon l'invention ;
- la figure 2 est un schéma électrique équivalent au circuit de mesure et à son accumulateur associé ;
- la figure 3 est une représentation illustrant la modélisation des inductances et capacités parasites dans une batterie ;
- la figure 4 est une représentation d'un exemple de structure logique mise en oeuvre dans un circuit de mesure selon l'invention ;
- la figure 5 est une représentation schématique d'un exemple de module de filtrage ;
- la figure 6 est une représentation schématique d'un exemple d'un oscillateur générant un signal d'horloge avec différents rapports cycliques ;
- la figure 7 est un diagramme représentatif d'une corrélation mesurée entre différentes transmissions dans une variante de codage.

L'invention propose de transmettre par courant porteur les mesures effectuées par différents capteurs à un dispositif de contrôle. La transmission est mise en oeuvre en abaissant la tension aux bornes de l'accumulateur mesuré. Un circuit de mesure est ainsi accolé à l'accumulateur et induit cette chute de tension en connectant une charge aux bornes de l'accumulateur. La transmission est ainsi effectuée par l'intermédiaire des connexions de puissance des accumulateurs connectés en série.

La tension permet de limiter les contraintes d'isolation galvanique du système et permet de réduire son coût en réduisant notamment le câblage de connexion nécessaire à la transmission des informations.

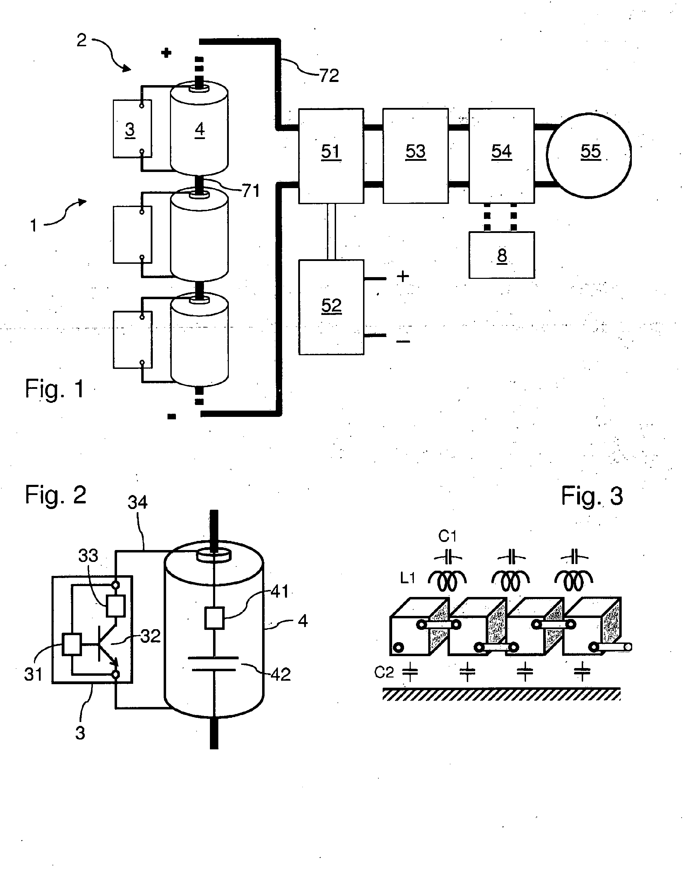

La figure 1 illustre schématiquement un système de batterie d'accumulateurs 1 selon l'invention, mis en oeuvre pour assurer l'entraînement d'un moteur électrique 55. Le système 1 comprend une batterie 2 incluant des accumulateurs électrochimiques 4 connectés en série. La batterie 2 comprend un grand nombre d'accumulateurs 4, typiquement entre 20 et 100 accumulateurs en fonction de la tension nécessaire et du type d'accumulateurs utilisé. Les accumulateurs 4 sont connectés en série par l'intermédiaire de connexions électriques de puissance 71. Chaque accumulateur 4 comporte un circuit 3 qui lui est accolé. Un circuit 3 est par exemple typiquement fixé sur son élément associé. Les circuits 3 ont à la fois une fonction de mesure de tension et une fonction de communication Les circuits 3 seront désignés par la suite par le terme commun de circuit de mesure.

La batterie 2 est connectée à un module de filtrage 51 par l'intermédiaire de connexions électriques de puissance 72. Un filtre d'antiparasitage électromagnétique 53, dit filtre CEM est également connecté à la batterie 2 par l'intermédiaire des connexions électriques de puissance 72. Le filtre 53 est connecté entre le module de filtrage 51 et un convertisseur alternatif/continu 54. Le convertisseur alternatif/continu 54 est également connecté aux connexions électriques 72 et forme l'interface entre la batterie 2 et les composants fonctionnant en courant alternatif, en l'occurrence un moteur électrique 55 et une source de courant alternatif de recharge 8.

Le filtre 53 permet de façon connue en soi d'éliminer les perturbations électromagnétiques sur le réseau continu lors du fonctionnement du moteur 55. Le filtre 53 permet notamment de filtrer les harmoniques de rang élevé qui peuvent être induites par les circuits de commutation de puissance des forts courants de charge ou de décharge. Le module de filtrage 51 démodule les informations fournies par les circuits de mesure 3. Le module de filtrage 51 fournit un signal basse tension correspondant au signal transmis par les circuits de mesure 3. Un dispositif de contrôle centralisé, formé en l'occurrence d'un calculateur 52 est connecté au module de filtrage 51 pour récupérer le signal basse tension. Le calculateur 52 peut être alimenté par un réseau basse tension, par exemple le réseau de bord d'un véhicule automobile. Du fait de la présence du filtre 53 entre le convertisseur 54 et le module de filtrage 51, les informations transmises par les circuits de mesure 3 ne sont pas perturbées par les harmoniques liées au hachage réalisé dans le convertisseur 54 ou dans la commande du moteur 55. Lorsque les informations transmises par les circuits de mesure sont codées, le calculateur 52 procède au décodage pour identifier par exemple le circuit de mesure émetteur et le contenu de l'information transmise (valeur de tension, alerte de seuil de tension haut, alerte de seuil de tension bas, température de l'accumulateur...). Chaque circuit de mesure 3 peut ainsi présenter un codage propre, par exemple par une largeur d'impulsion distinctive, par un motif de transmission distinctif ou par une fréquence de transmission distinctive. Le système 1 comprend des moyens permettant d'interrompre sélectivement la connexion électrique entre la batterie 2 du convertisseur 54. La batterie 2 peut ainsi être sélectivement isolée d'une charge électrique à alimenter ou d'une alimentation de recharge. Le module de filtrage 51 peut par exemple inclure des interrupteurs ouvrant les connexions électriques 72 entre la batterie et le convertisseur 54. Le calculateur 52 transmet par exemple des commandes d'ouverture de tels interrupteurs lors de la détection d'une fin de charge ou d'une décharge maximale. Le calculateur peut également commander une réduction du courant débité par la batterie 2 lorsque celle-ci atteint un seuil de décharge, afin de ne pas avoir à interrompre brutalement l'alimentation électrique de la charge électrique 55.

La figure 2 représente un schéma électrique équivalent à un circuit de mesure 3 et à son accumulateur associé 4. Le circuit 3 comprend une branche comportant en série un transistor de puissance 32 et une résistance de décharge 33. Cette branche est connectée en parallèle aux bornes de l'accumulateur 4 par l'intermédiaire d'un câble 34.

Le circuit 34 comprend également un microcontrôleur 31 connecté aux bornes de l'accumulateur 4. Le microcontrôleur 31 est configuré pour assurer une mesure de tension aux bornes de l'accumulateur 4. Le microcontrôleur 31 peut également être configuré pour mesurer d'autres paramètres de fonctionnement de l'accumulateur 4, par exemple sa température.

Le circuit de mesure 3 comporte un mode de fonctionnement statique dans lequel il mesure la tension aux bornes de l'accumulateur 4 et un mode de fonctionnement dynamique dans lequel il communique avec le calculateur 52.

En fonctionnement statique, le transistor 32 est bloqué. Dans ce fonctionnement statique, le microcontrôleur 31 réalise la mesure de la tension aux bornes de l'accumulateur 4.

En fonctionnement dynamique, le transistor 32 est passant. Dans ce fonctionnement dynamique, le microcontrôleur 31 communique avec le calculateur 52 en réalisant des baisses de tension aux bornes de l'accumulateur 4. Ces baisses de tension présentent une amplitude suffisante pour être détectées par le calculateur 52. Le microcontrôleur 31 communique ainsi par courant porteur avec le calculateur 52 par l'intermédiaire des connexions électriques de puissance 71 et 72. La communication peut être réalisée par des baisses de tension alternatives, à une fréquence prédéterminée.

Selon un modèle simplifié, l'accumulateur 4 est assimilable à une source de tension continue 42 connectée en série avec une impédance interne 41 dont l'ordre de grandeur est de 1mΩ. La branche du circuit 3 incluant le transistor de puissance 32 et la résistance de décharge 33 est avantageusement dimensionnée de sorte que le courant traversant cette branche ne soit pas négligeable rapport au courant de charge ou de décharge de la batterie 2. On pourra par exemple dimensionner la résistance 33 de sorte que la fermeture du transistor de puissance 32 induit une baisse de tension de l'accumulateur 4 l'ordre de 0,1 %, voire de l'ordre de 1%. Une baisse de tension subite de l'ordre de 0,1 % aux bornes de l'accumulateur 4 est aisément détectable, la tension aux bornes des accumulateurs 4 subissant normalement des variations relativement lentes. La baisse de tension induite par le circuit 3 peut également être exprimée en V : le circuit 3 induit ainsi avantageusement une baisse de tension comprise entre 1 et 10mV pour que celle-ci soit aisément détectable. La résistance 33 pourra par exemple présenter une valeur de l'ordre de 3Ω. Ainsi, si l'accumulateur est traversé par un courant de 100 A, la résistance 33 est traversée par un courant de 1 A durant la fermeture du transistor 32. Afin de limiter la consommation de courant dans le circuit 3, la résistance de décharge 33 présente une valeur au moins 50 fois supérieure à l'impédance interne de l'accumulateur 4 à la fréquence de transmission.

Bien que le circuit de mesure 3 ait été décrit sur la base d'un schéma incluant une résistance 33 et un transistor de puissance 32 en série, le circuit de mesure 3 peut être réalisé par tous moyens appropriés, par exemple en utilisant un transistor de puissance présentant une résistance de conduction permettant de générer une baisse de tension de l'accumulateur 4 avec l'ordre de grandeur souhaité.

Dans un mode de réalisation simplifié, la communication entre les circuits de mesure 3 et le calculateur 52 est unidirectionnelle. Un tel mode de réalisation permet notamment de réduire la complexité des circuits de mesure 3 et leur consommation électrique statique. On peut cependant également envisager d'établir une communication bidirectionnelle entre le circuit de mesure 3 et le calculateur 52.

La transmission d'informations entre le circuit de mesure 3 et le calculateur 52 par courant porteur peut être réalisée par toute technique de modulation connue. La transmission peut notamment être réalisée en bande de base ou par la modulation d'une porteuse.

Avec des circuits de mesure 3 indépendants les uns des autres, il est possible que plusieurs circuits de mesure 3 transmettent simultanément des informations au calculateur 52. Pour éviter des interférences entre ces transmissions, on pourra mettre en oeuvre de façon connue en soi des mécanismes de redondance ou de codes correcteurs d'erreur.

Un ensemble d'accumulateurs, tous connectés en série, peut être modélisé en haute fréquence comme une ligne à constantes localisées comme illustré à la figure 3. Les connexions de puissance entre deux accumulateurs en série se comportent comme une inductance L1, et chaque accumulateur se comporte comme une capacité C2 par rapport à la masse du véhicule et induisant une capacité C1 entre deux accumulateurs en série.

L'inductance L1 d'une connexion série entre accumulateurs sous forme de languette conductrice large et courte peut-être définie par la formule suivante:

$$L1 \approx 0,5 * \mu o * Lo$$

Avec $\mu o = 1,26$ µH/m et Lo la longueur de la languette.

Ainsi, les cumuls des inductances L1 et des capacités C2 à envisager pour un dimensionnement classique de batterie pour l'alimentation d'un moteur électrique de véhicule sont respectivement de l'ordre de 100 nH et 20 pF.

En partant de l'hypothèse que la batterie 2 comprend 80 accumulateurs 4 en série, la batterie 2 se comporte comme une ligne de 70 ohms d'impédance caractéristique avec une fréquence de coupure supérieure à 100 MHz.

La fréquence choisie pour la transmission d'informations par les circuits de mesure 3 sera avantageusement très inférieure à cette valeur, et sera par exemple comprise entre 10 kHz et 1 MHz. Dans cette gamme de fréquences, les effets de ligne de transmission des inductances L1 et des capacités C2 pourront être négligés.

Comme la résistance interne d'un accumulateur de forte puissance est relativement faible, on pourrait penser qu'il est délicat de provoquer à ses bornes des variations de tensions mesurables. Cependant, les inventeurs ont constaté que l'inductance d'un tel accumulateur est prépondérante par rapport à sa résistance pour le calcul de l'impédance, pour des fréquences dépassant 1 kHz. De plus, la résistance interne d'un accumulateur est très non-linéaire. Cette résistance est élevée pour de faibles courants de charge ou de décharge, et diminue fortement sous des courants plus élevés. Ainsi, le circuit de mesure 3 peut induire une variation de tension mesurable par des appels de courant suffisamment élevés à une fréquence supérieure à 1 kHz. Cette variation de tension est donc très supérieure au simple produit R x I, où R est la résistance interne d'un accumulateur et I le courant dans la résistance 33.

Les tensions et courants sur le réseau continu du système 1 étant relativement stables, les variations de l'impédance sur ce réseau sont limitées. Les impédances étant prévisibles et stables, la qualité de transmission par courant porteur est prédictible et fiable. Par ailleurs, les fréquences des harmoniques induites par des courants de charge ou de décharge sont connues et prévisibles. Le filtre 53 peut donc être spécifiquement prévu pour atténuer ces fréquences et les fréquences de transmission des circuits de mesure 3 pourront également être adaptées pour se démarquer de ces fréquences perturbatrices. Les fréquences de découpage d'un convertisseur 54 de moteur électrique de véhicule automobile sont généralement de l'ordre de 25 kHz, afin de ne pas créer de gêne sonore pour les utilisateurs.

Par conséquent, la fréquence de communication du circuit de mesure 3 est avantageusement comprise entre 100 kHz et 1 MHz.

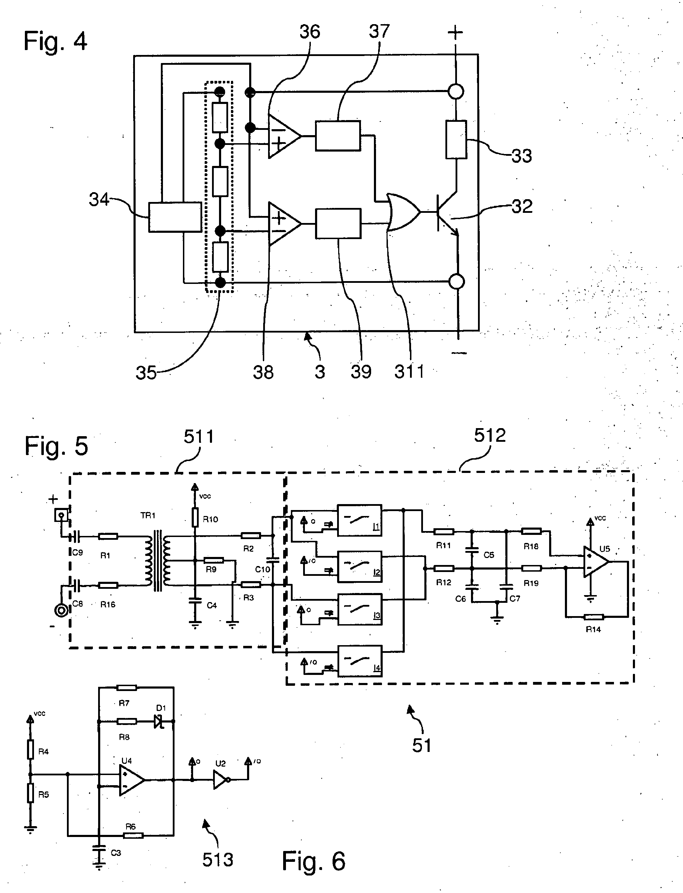

La figure 4 représente un exemple de structure logique mise en oeuvre dans un circuit de mesure 3. Le circuit de mesure 3 comporte un générateur 34. Le générateur 34 définit une différence de potentiel de référence. Le générateur 34 est alimenté par les connexions du circuit 3 aux bornes de l'accumulateur 4. Le générateur 34 applique une différence de potentiel calibrée aux bornes d'un diviseur de tension 35. Le diviseur de tension 35 est configuré pour définir un seuil de tension haut appliqué sur une première entrée d'un comparateur 36 et un seuil de tension bas appliqué sur une première entrée d'un comparateur 38. La tension aux bornes de l'accumulateur 4 est appliquée sur les deuxièmes entrées des comparateurs 36 et 38. Ainsi, si la différence de potentiel aux bornes de l'accumulateur 4 est supérieure au seuil haut, le comparateur 36 passe à l'état haut. Si la différence de potentiel aux bornes de l'accumulateur 4 est inférieure au seuil bas, le comparateur 38 passe à l'état haut.

Des circuits de hachage 37 et 39 sont connectés respectivement à la sortie du comparateur 36 et du comparateur 38. Les circuits de hachage 37 et 39 génèrent des signaux avec des rapports cycliques distincts, lorsqu'ils reçoivent un signal à l'état haut. Le circuit de hachage 37 peut par exemple générer un rapport cyclique fixe de 90 %. Le circuit de hachage 39 peut générer un rapport cyclique fixe de 10 %. Les sorties des circuits de hachage 37 et 39 sont connectées à l'entrée d'une porte OU 311. La sortie de la porte OU 311 est connectée à l'électrode de commande du transistor de puissance 32. Ainsi, si la différence de potentiel aux bornes de l'accumulateur 4 atteint l'un des seuils de tension, le transistor de puissance 32 est fermé à une fréquence prédéfinie avec le rapport cyclique correspondant au seuil atteint. La tension aux bornes de l'accumulateur 4 est ainsi rabaissée avec ce rapport cyclique.

Afin de limiter la décharge de l'accumulateur 4, le circuit de mesure 3 pourra limiter la durée de son fonctionnement dynamique. La transmission d'informations par le circuit de mesure 3 pourra être interrompue lorsque la tension aux bornes de l'accumulateur 4 franchit un seuil de coupure bas, afin d'éviter de poursuivre la décharge de cet accumulateur ayant déjà atteint sa limite de décharge.

Le rapport cyclique du circuit de hachage 37 est avantageusement relativement élevé, de sorte que le circuit de mesure 3 peut être utilisé pour dissiper le courant de charge de l'accumulateur 4 ayant atteint le seuil de tension haut, et ainsi participer à l'équilibrage de la charge des accumulateurs 4 de la batterie 2.

Le rapport cyclique du circuit de hachage 39 est avantageusement très bas, de sorte que la consommation électrique sur l'accumulateur 4 est très réduite lorsque cet accumulateur a atteint son seuil de tension bas.

Si la transmission d'informations par le circuit de mesure 3 est limitée au franchissement des seuils de tension par l'accumulateur 4, le circuit de mesure 3 n'est en fonctionnement dynamique que pendant une durée très brève. Par conséquent, la consommation électrique du circuit de mesure 3 est en moyenne extrêmement réduite.

Bien que cet exemple décrive une solution analogique, le circuit de mesure 3 peut également être réalisé en version numérique, par exemple à l'aide d'un microcontrôleur.

Le circuit de mesure 3 étant alimenté en permanence par son accumulateur 4 associé, celui-ci doit présenter une consommation en fonctionnement statique aussi réduite que possible. Le circuit de mesure 3 peut aisément être réalisé avec une consommation statique réduite, par exemple comprise entre 10 et 100 µA, ce qui correspond à l'ordre de grandeur du courant d'autodécharge usuel d'un accumulateur électrochimique.

Des alternatives à l'utilisation de rapports cycliques distincts pour le codage de l'information à transmettre au calculateur 52 peuvent bien entendu être utilisées. Pour éviter des interférences entre les transmissions des différents circuits de mesure 3, on pourra notamment mettre en oeuvre une communication vers le calculateur 52 basée sur des codes appropriés.

Le codage utilisé pour la communication d'un circuit de mesure 3 avec le calculateur 52 est ainsi destiné à permettre à la fois l'identification de ce circuit de mesure 3 et la lecture de la mesure de ce circuit au niveau du calculateur 52. Plusieurs circuits de mesure peuvent ainsi communiquer en simultané avec le calculateur 52 sans interférer entre eux.

On peut notamment utiliser un code d'étalement basé sur une séquence pseudo-aléatoire. Une séquence pseudo-aléatoire est une série de bits (0 ou 1) apparemment aléatoire mais qui est en réalité périodique. Une séquence transmise prend le nom de symbole. L'ensemble des symboles possibles respectant les mêmes propriétés prend le nom de code.

Deux caractéristiques de ces séquences sont avantageuses :

1. l'autocorrélation de chaque symbole est élevée. Une haute valeur d'autocorrélation sert à identifier un symbole transmis parmi plusieurs symboles reçus par un démodulateur.
2. l'intercorrélation entre symboles est faible. Une faible valeur d'intercorrélation évite les interférences entre symboles : un démodulateur peut alors fiablement les identifier de façon univoque même s'ils ont été reçus simultanément.

Selon une variante, on peut utiliser des codes basés sur les séquences à longueur maximale (Gold, Walsh, Kasami...). Ces codes présentent de très bonnes performances en termes d'autocorrélation.

On réalise l'acquisition des signaux transmis par les circuits de mesure 3. On détermine ensuite par exemple la corrélation entre le signal acquis et les différents codes, on identifie le circuit de mesure 3 et son information à l'aide d'un test d'hypothèses basé sur un seuil fixé en tenant compte du rapport signal sur bruit et du niveau d'interférences entre les cellules.

Le code Kasami présente par exemple de très bonnes propriétés d'autocorrélation et d'intercorrélation. Pour vérifier ces propriétés, des tests ont notamment été réalisés avec un code Kasami à 63 bits, qui permet d'avoir 16 symboles différents (suffisant pour 4 cellules et 3 valeurs d'information distinctes à transmettre pour chacune). Les tests ont été réalisés en laboratoire sur 4 cellules d'une batterie avec une fréquence d'envoi des bits de 200kHz, une fréquence d'envoi de symboles de 2Hz et une fréquence d'échantillonnage de 5MHz en acquisition (cette fréquence est supérieure à celles qui serait utilisée dans les applications envisagées, en vue d'évaluer le rapport signal sur bruit).

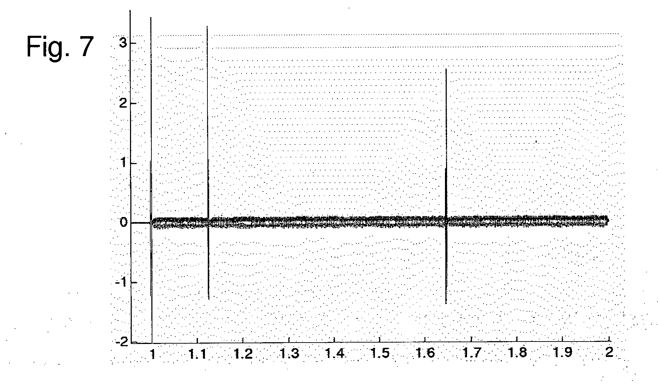

La figure 7 représente la corrélation d'un signal mesuré au niveau du calculateur 52 sur une fenêtre de temps de 200ms. On identifie ici la transmission de trois symboles par trois dispositifs de mesure 3 différents. Chaque pic correspond à un symbole distinct. Des pics beaucoup plus faibles sont induits par une intercorrélation non nulle entre les symboles, mais qui est cependant très réduite. En réalisant une opération de démodulation par corrélation sur le signal brut acquis avec un oscilloscope, on a estimé un rapport signal sur bruit de 19,6dB, sans aucune étape d'amplification ni filtrage.

Pour réduire la sensibilité de la transmission aux bruits électromagnétiques, il possible de réaliser la transmission par modulation d'une porteuse à fréquence nettement plus élevée, par exemple entre 1 et 30MHz. La porteuse peut être générée dans le circuit de mesure 3 par un circuit sur la base d'un oscillateur à quartz et la modulation peut se faire avec une porte de type EX-OR *(ou* exclusif). Une borne d'entrée de la porte reçoit la porteuse et une autre borne d'éntrée de la porte reçoit le code en bande de base, par exemple le code Kasami. On réalise ainsi une modulation de phase de type PSK, avec changement de phase de la porteuse de 180° lors d'un changement de bit.

Un code basé sur des séquences à longueur maximale (type m-sequence) sera avantageusement paramétré (longueur du code, performances de corrélation, nombre de symboles) en fonction de la vitesse de transmission disponible, du nombre d'états de l'information à transmettre ou de la mémoire d'un microcontrôleur du circuit de mesure 3.

Selon une autre variante, on utilise des codes dit orthogonaux, qui ont une intercorrélation nulle, mais une autocorrélation plus faible.

Pour concilier la communication des circuits de mesure 3 avec les fonctions de base du calculateur 52 (assurer l'équilibrage des accumulateurs, protéger les cellules contre les surcharges ou les décharges excessives), la communication intercale avantageusement des pauses entre les symboles transmis.

Pour limiter la consommation d'énergie par la transmission mise en oeuvre par les circuits de mesure, ces transmissions pourront n'intervenir que lorsque des conditions particulières de fonctionnement de la batterie sont détectées.

Les figures 5 et 6 illustrent un exemple de module de filtrage 51. Le module de filtrage 51 comprend un circuit de filtrage et d'abaissement du niveau de tension 511, un circuit d'échantillonnage 512 et un oscillateur 513 générant un signal d'horloge avec un rapport cyclique variable. Les bornes d'entrée du circuit 511 sont connectées aux bornes de la batterie 2 par l'intermédiaire des connexions de puissance 72. Le circuit 511 comprend un transformateur abaisseur de tension TR1 dont le primaire est connecté aux bornes d'entrée du circuit 511 respectivement par l'intermédiaire d'un condensateur C9 et d'une résistance R1 en série et par l'intermédiaire d'un condensateur C8 et d'une résistance R16 en série. Le secondaire du transformateur TR1 est connecté aux bornes de sortie du circuit 511 respectivement par l'intermédiaire de la résistance R2 et par l'intermédiaire de la résistance R3. Un condensateur C10 est connecté entre les bornes de sortie du circuit 511. Un point milieu du secondaire du transformateur TR1 est connecté à une alimentation basse tension Vcc par l'intermédiaire d'une résistance R10 et connecté à la masse par l'intermédiaire d'une résistance R9 et d'un condensateur C4 en parallèle.

L'oscillateur 513 génère sélectivement les signaux d'horloge complémentaires Q et /Q. Les signaux complémentaires Q et /Q peuvent présenter respectivement des rapports cycliques de 90 % et 10%. Le circuit 513 comprend des résistances R4 et R5 connectées en série entre la tension Vcc et la masse. Le circuit 513 comprend un amplificateur opérationnel U4 dont l'entrée non inverseuse est connectée à un noeud intermédiaire entre les résistances R4 et R5. L'entrée non inverseuse et connecté à la sortie de l'amplificateur U4 par l'intermédiaire d'une résistance R6. L'entrée inverseuse de l'amplificateur U4 est connectée à la masse par l'intermédiaire d'un condensateur C3. L'entrée inverseuse est connectée à la sortie de l'amplificateur U4 par l'intermédiaire de deux branches en parallèle : une première branche comprenant une résistance R7 et une deuxième branche comprenant une résistance R8 et une diode Zener D1 connectée en série (tout autre type de diode peut également être utilisé). La résistance R7 est approximativement 10 fois supérieure à R8 pour obtenir les rapports cycliques souhaités. En fonction du sens du courant dans la diode Zener D1, le condensateur C3 est chargé ou déchargé. La sortie de l'amplificateur U4 fournit le signal d'horloge Q avec un rapport cyclique de 90%. Un inverseur U2 est connecté à la sortie de l'amplificateur U4 et fournit le signal d'horloge complémentaire /Q avec un rapport cyclique de 10%.

Les bornes d'entrée du circuit d'échantillonnage 512 sont connectées aux bornes de sortie du circuit 511. Le circuit d'échantillonnage 512 comprend des interrupteurs I1, I2, I3 et I4. L'entrée des interrupteurs I1 et I2 est connectée à une première borne d'entrée du circuit 512, l'entrée des interrupteurs I3 et I4 est connectée à une deuxième borne d'entrée du circuit 512. L'entrée de commande des interrupteurs I1 et I3 est connectée au signal d'horloge Q. L'entrée de commande des interrupteurs I2 et I4 est connectée au signal d'horloge /Q. La sortie des interrupteurs I1 et I4 est connectée à l'entrée non inverseuse d'un amplificateur U5 par l'intermédiaire de résistances R11 et R18 connectées en série. La sortie des interrupteurs I2 et I3 est connectée à l'entrée inverseuse de l'amplificateur U5 par l'intermédiaire de résistances R12 et R19 connectées en série. Un condensateur C5 raccorde le noeud intermédiaire entre les résistances R11 et R18 et le noeud intermédiaire entre les résistances R12 et R19. Ces noeuds intermédiaires sont connectés à la masse respectivement par des condensateurs C6 et C7. Ces condensateurs C5 à C7 et R11, R12, R18 et R19 forment un circuit bloqueur des signaux échantillonnés. L'entrée inverseuse de l'amplificateur U5 est connectée à la sortie de celui-ci par l'intermédiaire d'une résistance R14. Le signal à la sortie de l'amplificateur U5 est fourni au calculateur 52.

La fréquence des signaux d'horloge Q et /Q générés par le circuit 513 est proche mais pas égale à la fréquence de modulation du circuit de mesure 3 en communication. Ainsi, le signal échantillonné par le circuit 512 présente une basse fréquence, proportionnelle à la différence entre la fréquence du signal d'horloge Q et la fréquence de communication du circuit de mesure 3. Un tel circuit 51 permet avantageusement de déterminer le rapport cyclique du signal généré par le circuit de mesure 3 malgré de potentielles perturbations sur les connexions de puissance 72. Le calculateur 52 peut déterminer le rapport cyclique du signal généré par le circuit de mesure 3 en mesurant les durées respectives des signaux positifs et négatifs sur la sortie de l'amplificateur U5.

Dans l'exemple illustré, chaque accumulateur 4 connecté en série comporte un circuit de mesure 3. L'invention s'applique également à des batteries comprenant plusieurs étages connectés en série, chaque étage comprenant plusieurs accumulateurs électrochimiques connectés en parallèle. Dans une telle configuration, un circuit de mesure 3 est connecté aux bornes de chaque étage.

Bien que la fonction de mesure et la fonction de communication soient mises en oeuvre par un même circuit 3 dans l'invention décrite précédemment, ces deux fonctions peuvent être mis en oeuvre par deux circuits distincts.

## Revendications

1. Système (1) de batterie d'accumulateurs, comprenant :

   - plusieurs accumulateurs électrochimiques (4) connectés en série ;
   - une connexion électrique de puissance (71,72) destinée à raccorder une charge électrique (55) ou une alimentation de recharge (8) auxdits accumulateurs électrochimiques (4) ;
   - un dispositif de contrôle (52) raccordé aux accumulateurs électrochimiques (4) par l'intermédiaire de la connexion électrique de puissance ;

   **caractérisé en ce que** :

   le système comprend en outre :

- plusieurs circuits de mesure (3), chacun de ces circuits de mesure étant accolé à un accumulateur électrochimique respectif et étant configuré pour mesurer la tension aux bornes de cet accumulateur respectif ;
- plusieurs circuits de communication, chacun de ces circuits de communication étant accolé à un accumulateur électrochimique respectif et étant configuré pour induire une baisse de tension aux bornes de cet accumulateur respectif lorsque la tension mesurée franchit un seuil ;
le dispositif de contrôle (52) est configuré pour identifier ladite baisse de tension.

2. Système selon la revendication 1, dans lequel les circuits de mesure (3) et les circuits de communication sont alimentés électriquement par leur accumulateur respectif (4).

3. Système selon la revendication 1 ou 2, dans lequel les circuits de communication (3) sont configurés pour induire une alternance de baisses de tension avec une fréquence comprise entre 10kHz et 1 MHz lorsque la tension mesurée franchit un seuil.

4. Système selon l'une quelconque des revendications précédentes, dans lequel les circuits de communication sont configurés pour induire une baisse de tension aux bornes de leur accumulateur respectif soit lorsque la tension aux bornes de cet accumulateur franchit une tension de charge maximale, soit lorsque la tension aux bornes de cet accumulateur franchit une tension de décharge minimale.

5. Système selon la revendication 4, dans lequel les circuits de communication sont configurés pour induire une baisse de tension pour la tension de charge maximale avec un rapport cyclique supérieur au rapport cyclique de la baisse de tension pour la tension de décharge minimale.

6. Système selon l'une quelconque des revendications précédentes, dans lequel les circuits de communication sont configurés pour réaliser des baisses de tension distinctes, le dispositif de contrôle étant configuré pour identifier un circuit de communication en fonction de la baisse de tension réalisée.

7. Système selon l'une quelconque des revendications 1 à 4, dans lequel les circuits de communication sont configurés pour coder un identifiant du circuit de mesure par code pseudo-aléatoire lorsque ce circuit de mesure (3) mesure une tension aux bornes de son accumulateur franchissant un seuil.

8. Système selon l'une quelconque des revendications précédentes, comprenant :

- un convertisseur continu/alternatif connecté à la connexion électrique de puissance ;
- un filtre antiparasitage interposé entre le convertisseur et le dispositif de contrôle.

9. Système selon l'une quelconque des revendications précédentes comprenant plus de vingt accumulateurs connectés en série, la tension aux bornes de la batterie (2) étant supérieure à 50V.

10. Système selon l'une quelconque des revendications précédentes, dans lequel les circuits de communication sont configurés pour induire une baisse de tension d'au moins 0,1 % aux bornes de leur accumulateur lorsque la tension mesurée franchit un seuil.

11. Système selon l'une quelconque des revendications précédentes, dans lequel les circuits de communication induisent une baisse de tension aux bornes de leur accumulateur par connexion d'une charge électrique (33) entre les bornes de leur accumulateur.

12. Procédé de gestion de la charge d'accumulateurs électrochimiques en série d'une batterie, comprenant les étapes de :

- mesure de la tension aux bornes des accumulateurs (4) par l'intermédiaire de circuits de mesure (3) accolés à des accumulateurs respectifs ;
- détection du franchissement d'un seuil de tension aux bornes de son accumulateur respectif par un desdits circuits de mesure ;
- génération d'une baisse de tension aux bornes de l'accumulateur pour lequel le franchissement a été détecté ;
- détection de la baisse de tension par un dispositif de contrôle (52) raccordé aux accumulateurs électrochimiques par l'intermédiaire d'une connexion électrique de puissance (72) raccordant une charge électrique (55) ou une alimentation de recharge (8) auxdits accumulateurs.

13. Procédé de gestion de la charge d'accumulateurs électrochimiques d'une batterie selon la revendication 12, comprenant l'alimentation des circuits de mesure par leur accumulateur respectif.

14. Procédé de gestion de la charge d'accumulateurs électrochimiques d'une batterie selon la revendication 12 ou 13, dans lequel ladite génération d'une baisse de tension inclut une alternance de baisses de tension aux bornes dudit accumulateur avec une fréquence comprise entre 10kHz et 1 MHz.

15. Procédé de gestion de la charge d'accumulateurs électrochimiques d'une batterie selon la revendication 12, 13 ou 14, dans lequel la génération d'une baisse de tension comprend la connexion d'un élément électrique aux bornes dudit accumulateur, ledit élément électrique étant configuré pour induire une baisse de tension d'au moins 0,1 % aux bornes dudit accumulateur lors de sa connexion.

**Patentansprüche**

1. Akkumulatorenbatteriesystem (1), das enthält:

    - mehrere in Reihe geschaltete elektrochemische Akkumulatoren (4);
    - eine elektrische Leistungsverbindung (71, 72), die dazu bestimmt ist, eine elektrische Last (55) oder ein Auflade-Netzteil (8) an die elektrochemischen Akkumulatoren (4) anzuschließen;
    - eine Kontrollvorrichtung (52), die an die elektrochemischen Akkumulatoren (4) mittels der elektrischen Leistungsverbindung angeschlossen ist;

    **dadurch gekennzeichnet, dass**:

    das System außerdem enthält:

    - mehrere Messschaltkreise (3), wobei jeder dieser Messschaltkreise an einen jeweiligen elektrochemischen Akkumulator angefügt und konfiguriert ist, die Spannung an den Klemmen dieses jeweiligen Akkumulators zu messen;
    - mehrere Kommunikationsschaltkreise, wobei jeder dieser Kommunikationsschaltkreise an einen jeweiligen elektrochemischen Akkumulator angefügt und konfiguriert ist, einen Spannungsabfall an den Klemmen dieses jeweiligen Akkumulators zu induzieren, wenn die gemessene Spannung eine Schwelle überschreitet; die Kontrollvorrichtung (52) konfiguriert ist, den Spannungsabfall zu erkennen.

2. System nach Anspruch 1, wobei die Messschaltkreise (3) und die Kommunikationsschaltkreise von ihrem Akkumulator (4) mit Strom versorgt werden.

3. System nach Anspruch 1 oder 2, wobei die Kommunikationsschaltkreise (3) konfiguriert sind, eine Wechselfolge von Spannungsabfällen mit einer Frequenz zwischen 10kHz und 1MHz zu induzieren, wenn die gemessene Spannung eine Schwelle überschreitet.

4. System nach einem der vorhergehenden Ansprüche, wobei die Kommunikationsschaltkreise konfiguriert sind, einen Spannungsabfall an den Klemmen ihres Akkumulators zu induzieren, entweder, wenn die Spannung an den Klemmen dieses Akkumulators eine maximale Ladespannung überschreitet, oder wenn die Spannung an den Klemmen dieses Akkumulators eine minimale Entladespannung überschreitet.

5. System nach Anspruch 4, wobei die Kommunikationsschaltkreise konfiguriert sind, einen Spannungsabfall für die maximale Ladespannung mit einem höheren zyklischen Verhältnis als das zyklische Verhältnis des Spannungsabfalls für die minimale Entladespannung zu induzieren.

6. System nach einem der vorhergehenden Ansprüche, wobei die Kommunikationsschaltkreise konfiguriert sind, unterschiedliche Spannungsabfälle zu erzeugen, wobei die Kontrollvorrichtung konfiguriert ist, einen Kommunikationsschaltkreis abhängig vom erzeugten Spannungsabfall zu erkennen.

7. System nach einem der Ansprüche 1 bis 4, wobei die Kommunikationsschaltkreise konfiguriert sind, eine Kennung des Messschaltkreises durch einen pseudo-zufälligen Code zu codieren, wenn dieser Messschaltkreis (3) eine Spannung an den Klemmen seines Akkumulators misst, die eine Schwelle überschreitet.

8. System nach einem der vorhergehenden Ansprüche, das enthält:

    - einen Wechselrichter, der mit der elektrischen Leistungsverbindung verbunden ist;
    - einen Entstörungsfilter, der zwischen den Wechselrichter und die Kontrollvorrichtung eingefügt ist.

9. System nach einem der vorhergehenden Ansprüche, das mehr als zwanzig in Reihe geschaltete Akkumulatoren enthält, wobei die Spannung an den Klemmen der Batterie (2) höher als 50 V ist.

10. System nach einem der vorhergehenden Ansprüche, wobei die Kommunikationsschaltkreise konfiguriert sind, einen Spannungsabfall von mindestens 0,1 % an den Klemmen ihres Akkumulators zu induzieren, wenn die gemessene Spannung eine Schwelle überschreitet.

11. System nach einem der vorhergehenden Ansprüche, wobei die Kommunikationsschaltkreise einen Spannungsabfall an den Klemmen ihres Akkumulators durch Verbindung einer elektrischen Last (33) zwischen den Klemmen ihres Akkumulators induzieren.

**12.** Verfahren zur Verwaltung der Ladung in Reihe geschalteter elektrochemischer Akkumulatoren einer Batterie, das die folgenden Schritte enthält:

> - Messen der Spannung an den Klemmen der Akkumulatoren (4) mit Hilfe von Messschaltkreisen (3), die an jeweilige Akkumulatoren angefügt sind;
> - Erfassen der Überschreitung einer Spannungsschwelle an den Klemmen seines jeweiligen Akkumulators durch einen der Messschaltkreise;
> - Erzeugen eines Spannungsabfalls an den Klemmen des Akkumulators, für den die Überschreitung erfasst wurde;
> - Erfassen des Spannungsabfalls durch eine Kontrollvorrichtung (52), die an die elektrochemischen Akkumulatoren mittels einer elektrischen Leistungsverbindung (72) angeschlossen ist, die eine elektrische Last (55) oder ein Auflade-Netzteil (8) an die Akkumulatoren anschließt.

**13.** Verfahren zur Verwaltung des Ladens elektrochemischer Akkumulatoren einer Batterie nach Anspruch 12, das die Versorgung der Messschaltkreise durch ihren Akkumulator enthält.

**14.** Verfahren zur Verwaltung des Ladens elektrochemischer Akkumulatoren einer Batterie nach Anspruch 12 oder 13, wobei die Erzeugung eines Spannungsabfalls eine Wechselfolge von Spannungsabfällen an den Klemmen des Akkumulators mit einer Frequenz zwischen 10 kHz und 1 MHz umfasst.

**15.** Verfahren zur Verwaltung des Ladens elektrochemischer Akkumulatoren einer Batterie nach Anspruch 12, 13 oder 14, wobei die Erzeugung eines Spannungsabfalls die Verbindung eines elektrischen Elements mit den Klemmen des Akkumulators enthält, wobei das elektrische Element konfiguriert ist, einen Spannungsabfall von mindestens 0,1 % an den Klemmen des Akkumulators bei seiner Verbindung zu

**Claims**

**1.** System (1) of battery of accumulators, comprising:

> - several electrochemical accumulators (4) connected in series;
> - an electrical power connection (71,72) intended to link an electrical load (55) or a recharging supply (8) to the said electrochemical accumulators (4);
> - a control device (52) linked to the electrochemical accumulators (4) by way of the electrical power connection;

**characterized in that**:

> the system furthermore comprises:

> - several measurement circuits (3), each of these measurement circuits being adjoined with a respective electrochemical accumulator and being configured to measure the voltage across the terminals of this respective accumulator;
> - several communication circuits, each of these communication circuits being adjoined with a respective electrochemical accumulator and being configured to induce a voltage dip across the terminals of this respective accumulator when the measured voltage crosses a threshold;
> the control device (52) is configured to identify the said voltage dip.

**2.** System according to Claim 1, in which the measurement circuits (3) and the communication circuits are supplied electrically by their respective accumulator (4).

**3.** System according to Claim 1 or 2, in which the communication circuits (3) are configured to induce an alternation of voltage dips with a frequency lying between 10 kHz and 1 MHz when the measured voltage crosses a threshold.

**4.** System according to any one of the preceding claims, in which the communication circuits are configured to induce a voltage dip across the terminals of their respective accumulator either when the voltage across the terminals of this accumulator crosses a maximum charge voltage, or when the voltage across the terminals of this accumulator crosses a minimum discharge voltage.

**5.** System according to Claim 4, in which the communication circuits are configured to induce a voltage dip for the maximum charge voltage with a greater duty cycle than the duty cycle of the voltage dip for the minimum discharge voltage.

**6.** System according to any one of the preceding claims, in which the communication circuits are configured to achieve distinct voltage dips, the control device being configured to identify a communication circuit as a function of the voltage dip achieved.

**7.** System according to any one of Claims 1 to 4, in which the communication circuits are configured to code an identifier of the measurement circuit by pseudo-random code when this measurement circuit (3) measures a voltage across the terminals of its accumulator crossing a threshold.

**8.** System according to any one of the preceding claims, comprising:

> - a DC/AC converter connected to the electrical power connection;
> - an interference suppression filter interposed between the converter and the control device.

**9.** System according to any one of the preceding claims comprising more than twenty accumulators connected in series, the voltage across the terminals of the battery (2) being greater than 50 V.

**10.** System according to any one of the preceding claims, in which the communication circuits are configured to induce a voltage dip of at least 0.1 % across the terminals of their accumulator when the measured voltage crosses a threshold.

**11.** System according to any one of the preceding claims, in which the communication circuits induce a voltage dip across the terminals of their accumulator by connection of an electrical load (33) between the terminals of their accumulator.

**12.** Method for managing the charging of electrochemical accumulators in series of a battery, comprising the steps of:

> - measurement of the voltage across the terminals of the accumulators (4) by way of measurement circuits (3) adjoined with respective accumulators;
> - detection of the crossing of a threshold of voltage across the terminals of its respective accumulator by one of the said measurement circuits;
> - generation of a voltage dip across the terminals of the accumulator for which the crossing has been detected;
> - detection of the voltage dip by a control device (52) linked to the electrochemical accumulators by way of an electrical power connection (72) linking an electrical load (55) or a recharging supply (8) to the said accumulators.

**13.** Method for managing the charging of electrochemical accumulators of a battery according to Claim 12, comprising the supplying of the measurement circuits by their respective accumulator.

**14.** Method for managing the charging of electrochemical accumulators of a battery according to Claim 12 or 13, in which the said generation of a voltage dip includes an alternation of voltage dips across the terminals of the said accumulator with a frequency lying between 10 kHz and 1 MHz.

**15.** Method for managing the charging of electrochemical accumulators of a battery according to Claim 12, 13 or 14, in which the generation of a voltage dip comprises the connection of an electrical element to the terminals of the said accumulator, the said electrical element being configured to induce a voltage dip of at least 0.1 %

Fig. 1

Fig. 2

Fig. 3

Fig. 4

Fig. 5

Fig. 6

Fig. 7

**EP 2 721 684 B1**

**RÉFÉRENCES CITÉES DANS LA DESCRIPTION**

**Documents brevets cités dans la description**

- JP 2009089453 A